Europäisches Patentamt

European Patent Office

Office européen des brevets

(19)

(11) Publication number: **0 091 199**
**B1**

(12) **EUROPEAN PATENT SPECIFICATION**

(45) Date of publication of patent specification: **27.08.86**

(51) Int. Cl.⁴: **G 03 B 41/00**

(21) Application number: **83301169.5**

(22) Date of filing: **04.03.83**

(54) Projection alignment apparatus.

(30) Priority: **05.04.82 US 365765**

(43) Date of publication of application:
**12.10.83 Bulletin 83/41**

(45) Publication of the grant of the patent:
**27.08.86 Bulletin 86/35**

(84) Designated Contracting States:
**DE FR GB**

(56) References cited:
**US-A-3 748 015**
**US-A-4 118 126**
**US-A-4 215 934**

**SOLID STATE TECHNOLOGY, vol. 17, no. 6,
June 1974, pages 50-53, Port Washington, USA
D.A. MARKLE: "A new projection printer"**

**IBM TECHNICAL DISCLOSURE BULLETIN, vol.
22, No. 10, March 1980, pages 4505-4507, New
York, USA J.J. NAHLIK et al.: "Exposure mask
diagnostic and disposition targets"**

**IBM TECHNICAL DISCLOSURE BULLETIN, vol.
23, no. 4, September 1980, pages 1498, 1499,
New York, USA A. FROSCH et al.: "Vernier
scale"**

(73) Proprietor: **CONTROL DATA CORPORATION
8100-34th Avenue South
Minneapolis Minnesota 55440 (US)**

(72) Inventor: **Betz, Donald Wayne
3852 Ballantrae, Apt.10
Eagan Minnesota 55122 (US)**

(74) Representative: **Caro, William Egerton et al
J. MILLER & CO. Lincoln House 296-302 High
Holborn
London WC1V 7JH (GB)**

Courier Press, Leamington Spa, England.

# Description

This invention relates to projection alignment apparatus, for example, for use in the fabrication of microminiature integrated circuits on silicon wafers.

Projection alignment apparatus is employed to project a light image of a circuit pattern onto a wafer. The circuit pattern is then etched on the wafer using photoresist techniques. The light image is focused on the wafer by means of an optical system consisting of a plurality of mirrors. It is critical that these mirrors be properly aligned to project accurately the circuit image on the wafer. In the past, there has been no simple and straight-forward way of aligning these mirrors, or, where perfect alignment is not possible, of measuring misalignment errors.

In an article by D. A. Markle entitled "A New Projection Printer" (Solid State Technology, Vol. 17, No. 6, June 1974, pages 50—53, Port Washington, U.S.A.), and in US—A—4215934 and US—A—3748015 there is disclosed a projection alignment apparatus comprising: a circuit mask holder, suitable for securing a circuit mask, said circuit mask having a circuit pattern thereon; means for securing a wafer in a wafer plane, an optical system, and a light source for projecting light through said circuit mask to produce an image of said circuit pattern through said optical system on said wafer. The present invention is characterised by comprising: a first target mask having at least two lines of first alignment patterns thereon, at least one of said first lines extending vertically through the centre of the first target mask, at least one of said first lines extending horizontally through said centre, a horizontally disposed pattern on each of said first alignment patterns comprising a comb pattern having a plurality of teeth arranged in a vertically extending row including a central tooth, the teeth being evenly spaced a first predetermined distance apart and a vertically disposed pattern on each of said first alignment patterns comprising a comb pattern having a plurality of teeth arranged in a horizontally extending row including a central tooth, the teeth being evenly spaced the first predetermined distance apart, said first target mask being secured in said mask holder; a second target mask having at least two lines of second alignment patterns thereon, at least one of said second lines extending vertically through the centre of the second target mask, at least one of said second lines extending horizontally through said centre, a horizontally disposed pattern on each of said second alignment patterns comprising a comb pattern having a plurality of teeth arranged in a vertically extending row including a central tooth, the teeth being evenly spaced a second predetermined distance apart and a vertically disposed pattern on each of said second alignment patterns comprising a comb pattern having a plurality of teeth arranged in a horizontally extending row including a central tooth, the teeth being evenly spaced the second predetermined distance apart; said second target mask being secured in said wafer plane, said light source being arranged to project light through said first target mask to carry the image of said first alignment patterns through said optical system and be superimposed upon said second target mask, means for arranging said horizontally and vertically disposed patterns of the first target mask so that their images abut the corresponding horizontally and vertically disposed patterns of the second target mask in an aligned position where the central teeth of the respective patterns are aligned, the first and second predetermined distances being such that the alignment of teeth other than the central teeth provides a direct measurement of the degree and direction of misalignment.

Preferably the apparatus includes means for producing relative movement between said first target mask and said second target mask to attempt to put said first alignment patterns and said second alignment patterns in said aligned position.

Said first target mask may have at least four lines of first alignment patterns thereon, at least two of which are vertically extending on opposite sides of the centre of the first target mask, and at least two of said lines being horizontally extending on opposite sides of the centre of the first target mask, said second target mask having at least four lines of second alignment patterns thereon, at least two of which are vertically extending on opposite sides of the centre of the second target mask, and at least two of said lines being horizontally extending on opposite sides of, the centre of the second target mask. Said at least four lines of first alignment patterns of said first target mask may be superimposed upon and aligned with said at least four lines of second alignment patterns of said second target mask in said aligned position.

In the illustrated embodiment said first target mask includes at least first alignment patterns disposed on each side of said centre of the first target mask along diagonal lines running through said centre of the first target mask from an upper left hand corner to a lower right hand corner and from a lower left hand corner of said mask to an upper right hand corner, and that said second target mask includes second alignment patterns disposed on each side of said centre of the second target mask along diagonal lines running through said centre of the second target mask from an upper left hand corner to a lower right hand corner and from a lower left hand corner to an upper right corner of said mask; the arrangement being such that in said aligned position, each of said first alignment patterns is superimposed upon and aligned with a corresponding second alignment pattern.

Alternatively each of said first alignment patterns has a pattern centre and one of said horizontally disposed patterns is disposed to the left of said pattern centre and one of said horizontally disposed patterns is disposed to the right of said pattern centre, and one of said vertically disposed patterns is disposed above said pattern centre and one of said vertically disposed patterns is disposed below said pattern centre. Thus each of said second alignment patterns may have a pattern centre and one of said horizontally disposed patterns is disposed to the left of said pattern centre and one of said horizontally disposed patterns is disposed to the right of said pattern centre, and one of said vertically disposed patterns is disposed above said pattern centre, and one of said vertically disposed patterns is disposed below said pattern centre. Preferably said horizontally and vertically disposed patterns of each of said first alignment patterns are arranged in a first box type configuration, and said horizontally and vertically disposed patterns of each of said second alignment pattern are disposed in a second box type configuration, the arrangement being such that in said aligned position said horizontally and vertically disposed patterns of each of said second alignment patterns fit within the first box type configuration and abut said horizontal and vertical patterns of the corresponding second alignment pattern.

Each of said second alignment patterns may have a cross hair disposed at its centre and each said first alignment pattern has a crosshair bracket disposed at its centre, said cross hair being centred in said cross hair bracket in said aligned position.

The invention is illustrated, merely by way of example, in the accompanying drawings, in which:—

Figure 1 is a schematic diagram of a conventional projection alignment apparatus;

Figure 2 is a plan view of a first target mask of a projection alignment apparatus according to the present invention with an array of first alignment patterns which are indicated by simple, undetailed representations only;

Figure 3 is a plan view of the second target mask of a projection alignment apparatus according to the present invention with an array of second alignment patterns which are indicated by simple, undetailed representations only;

Figure 4 is a detailed view of one of the first alignment patterns of Figure 2;

Figure 5 is a detailed view of one of the second alignment patterns of Figure 3;

Figure 6 is a detailed view of the first and second alignment patterns in an aligned position; and

Figure 7 is an enlarged view of a cooperating pair of combs of the alignment patterns in the aligned position.

In the following description and claims the terms "left", "right", "above", "below" etc. refer to the directions as seen in the drawings.

The fabrication of microminiature integrated circuits generally requires that a circuit pattern be formed on a mask, and then, by projecting light through the mask, the circuit pattern is reproduced as an identical light pattern, or image, upon a silicon wafer. The image projected on the wafer is etched according to well known photoresist techniques to transfer the circuit pattern from the mask to the wafer.

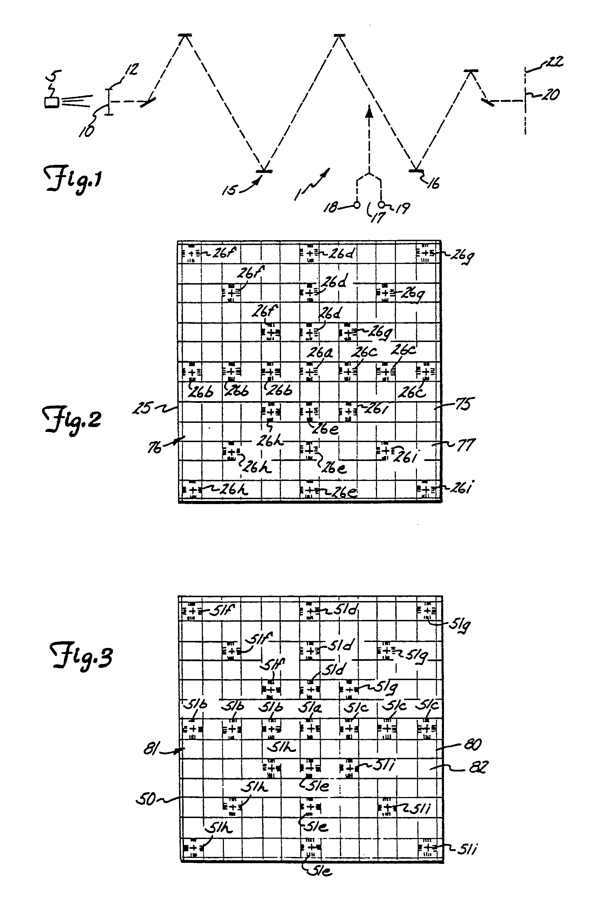

Figure 1 shows a mask 10 and a wafer 20 installed in a conventional projection alignment apparatus 1. An example of the type of projection alignment apparatus with which the invention can be employed is the Perkin-Elmer MICRALIGN Model 120. The mask 10 is installed in a mask holder 12. The wafer 20 is installed in a wafer plane 22 by a wafer chuck (not shown). The mask 10 and the wafer 20 are positioned on opposite sides of an optical system 15 composed of a plurality of mirrors 16. It is to be noted that the optical system 15 is only shown in a schematic fashion in that a detailed explanation of the optics is not essential to the understanding of the present invention. A light source 5 projects light through the mask 10 carrying the circuit pattern through the mirrors 16 of the optical system 15 to the wafer 20. A view 17 composed of telescopes 18, 19 is provided so that the overlay of the circuit pattern image on the wafer can be observed by the operator. Means (not shown) are provided to produce adjustable relative movement between the mask 10 and the wafer 20 so that the position of the circuit pattern image can be properly aligned upon the wafer 20. Means (not shown) are also provided to position adjustably the mirrors 16 to vary the shape, size and orientation of the projected circuit pattern image.

In order to fabricate high quality, reliable microminiature integrated circuits, it is essential that the mirrors 16 of the optical system 15 be precisely aligned to ensure that the circuit pattern image is accurately shaped and focused on the wafer 20. It is preferred to produce an exact 1:1 image of the circuit pattern on the wafer 20. The wafer lies in a two dimensional X—Y plane. Ideally the image is properly positioned in the X—Y plane with all rotational and magnification errors removed. To accomplish this proper positioning of the circuit pattern image, the relative positions of the mask 10 and the wafer 20 are adjustable; and, in addition, the mirrors can be adjusted if necessary. Due to the microscopic level at which the alignments must be made, however, it is sometimes the case that errors are present in the projection alignment apparatus 1 which cannot be removed by adjustments to the mirrors 16 of the optical system 15. In the past there has been no simple or straightforward way of determining when the mirrors were out of alignment, and even where mirror alignment errors have been detected, there has been no good means for adjusting the mirrors into proper alignment, or for measuring the amount of error present.

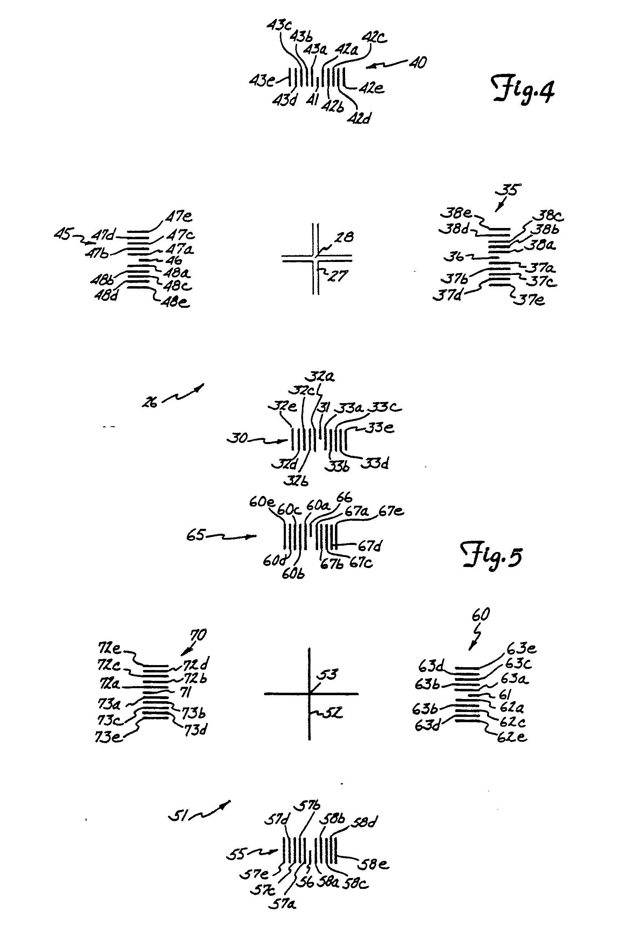

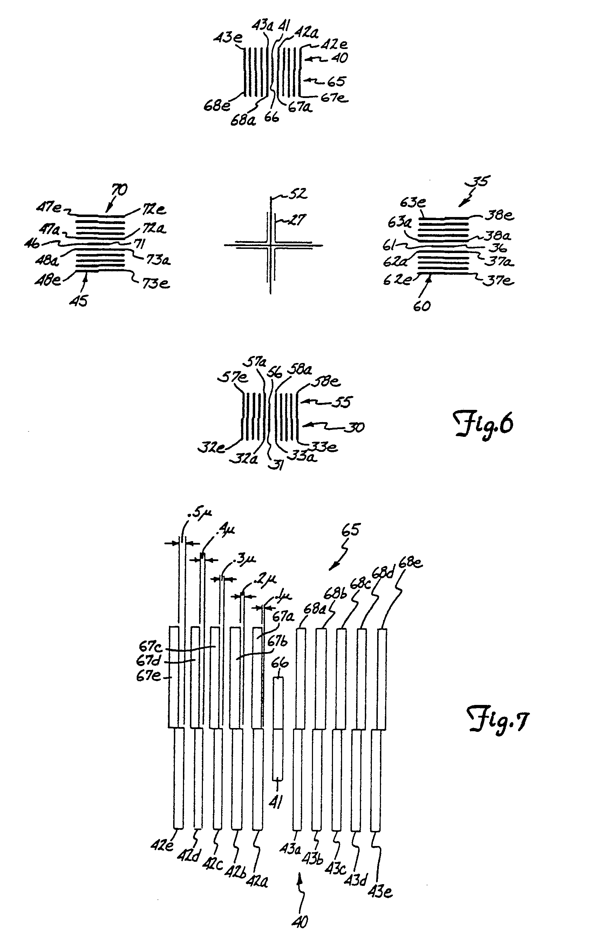

The present invention employs a pair of masks, namely, a first target mask 25 and a second target mask 50. The first target mask 25 (Figure 2) has an array of first alignment patterns 26 deposited thereon. Likewise, the second target mask 50 (Figure 3) has an array of corresponding second alignment patterns 51 formed thereon. The first alignment patterns 26 are shown in detail in Figure 4, while the corresponding second alignment patterns 51 are shown in detail in Figure 5. Figure 6 shows the image of one of the first alignment patterns 26 superimposed upon, and aligned with one of the second alignment patterns 51. These cooperating alignment patterns 26, 51 are utilised to determine and correct optical alignment errors as will be hereinafter described in detail.

The first target mask 25 is secured in the mask holder 12. The second target mask 50 is somewhat larger than a silicon wafer in size and is secured in the wafer plane 22. In brief, the light source 5 projects light through the first target mask 25 to carry images of the first alignment patterns 26 through the optical system 15 to impinge up the corresponding second alignment patterns 51 of the second target mask 50. The first target mask 25 is movably positioned with respect to the second target mask 50 (or vice versa) to attempt to align each of the first alignment patterns 26 with its corresponding second alignment pattern 51 to produce a perfect alignment, such as that shown in Figure 6. If such a perfect alignment cannot be made as to each first alignment pattern 26 and corresponding second alignment pattern 51, the mirrors 16 are adjusted to attempt to produce a perfect alignment. If the mirrors 16 cannot be adjusted to produce such alignment, the non-adjustable built-in error in the projection alignment apparatus can be determined directly from the cooperating alignment patterns 26, 51, and compared with the required specifications for the microminiature integrated circuit to be fabricated to determine whether the alignment error is within allowable limits.

Turning now to describe the alignment patterns 26, 51, more specifically, attention is first directed to Figure 4 which shows one of the first alignment patterns 26 in detail.

The first alignment patterns 26 are formed on the first target mask 25 by conventional circuit mask fabrication methods. With reference to Figure 4, each first alignment pattern 26 comprises four combs 30, 35, 40, 45 and a cross hair bracket 27. Each of the combs 30, 35, 40, 45 comprises a plurality of teeth arranged in a row, and each comb has a central tooth 31, 36, 41, 46 respectively. Each of the combs 30, 35, 40, 45 comprises a first comb pattern and the patterns are either horizontally or vertically disposed. Combs 30, 40 are horizontally disposed first comb patterns, while combs 35, 45 are vertically disposed first comb patterns. The first alignment pattern 26 has a centre 28. The combs 30, 40 are disposed above and below the centre 28 respectively, while the combs 35, 45 are disposed to the right and left, respectively, of the centre 28 in Figure 4. The comb 30 has teeth 32a-32e arranged to the left of the central tooth 31 and teeth 33a-33e arranged to the right of the tooth 31. Likewise the comb 35 has teeth 37a-37e below the central tooth 36, and teeth 38a-38e above the central tooth 36. The comb 40 has teeth 42a-42e to the right of the central tooth 41 and teeth 43a-43e to the left of central tooth 41. The comb 45 has teeth 47a-47e above the central tooth 46 and teeth 48a-48e below the central tooth 46.

One of the second alignment patterns 51 is best shown in Figure 5. The second alignment patterns 51 are formed on the second target mask 50 by conventional circuit mask fabrication techniques. Each second alignment pattern 51 comprises four combs 55, 60, 65, 70, and a crosshair 52 comprised of orthogonal lines intersecting at a centre 53 of the second alignment pattern 51. Each of the combs 55, 60, 65, 70 comprises a plurality of teeth arranged in a row, and each comb has a central tooth 56, 61, 66, 71, respectively. Each of the combs 55, 60, 65, 70 comprises a second comb pattern, and each is either horizontally or vertically disposed. Combs 55, 65 are horizontally disposed second comb patterns, while combs 60, 70 are vertically disposed second comb patterns. The combs 55, 65 are disposed below and above the centre 53 respectively, while the vertically disposed combs 60, 70 are disposed to the right and left of the centre 53 respectively. The comb 55 has teeth 57a-57e arranged to the left of the central tooth 56, and teeth 58a-58e arranged to the right of the central tooth 56. Likewise, the comb 60 has teeth 62a-62e arranged below the central tooth 61, and teeth 63a-63e arranged above the central tooth 61. The comb 65 has teeth 67a-67e arranged to the right of the central tooth 66 and teeth 68a-68e arranged to the left of the central tooth 66. The comb 70 has teeth 72a-72e arranged above the central tooth 71 and teeth 73a-73e are arranged below the central tooth 71.

Figure 6 shows one of the first alignment patterns 26 and the corresponding second alignment pattern 51 in an aligned position. Note, that in actuality the operator would see the *image* of the first alignment pattern 26 superimposed upon the second alignment pattern 51. Thus, the operator does not actually see the first alignment pattern 26 of the first target mask 25, but rather, the image of that first alignment pattern. For simplicity of discussion, however, the image of the first alignment pattern 26 superimposed on the second alignment pattern 51 will be referred to simply as the first alignment pattern 26 rather than the image of the first alignment pattern 26. In the aligned position shown in Figure 6, the cross hair 52 is centred within crosshair bracket 27, and each of the central teeth 31, 36, 41, 46 of the combs 30, 35, 40, 45 are aligned with the corresponding central teeth 56, 61, 66 and 71 of the combs 55, 60, 65, 70. In this aligned position the teeth of the combs 30, 35, 40, 45 directly abut the teeth of the combs 55, 60, 65, 70. The combs 30, 35, 40, 45 form a first box type configuration which encloses the combs 55, 60, 65, 70 which form a second box type configuration. Note that except for the pairs of central teeth 31, 56; 36, 61; 41, 66; 46, 71 the other teeth of the combs patterns are misaligned, or offset. Moreover, the offset for each pair of combs increases with the distance the teeth are located from the central tooth. Figure 7 which is an enlarged view of the pair of combs 40, 65 clearly shows this. As shown, in Figure 7, only the central teeth 41, 66 are aligned, and the tooth 67a is offset from the tooth 42a by 0.1 micron; the tooth 67b is offset from the tooth 42b by 0.2 microns; the tooth 67c is offset from the tooth 42c by 0.3 microns; the tooth 67d is offset from the tooth 42d by 0.4 microns; and the tooth 67e is offset from the tooth 42e by 0.5 microns. The same arrangement is present for the teeth 43a-43e and the teeth 68a-68e, which are to the right of the central teeth 41, 66 in Figure 7, in that each of the combs is symmetrically constructed about its central tooth. This deliberate offset between the teeth of each comb of the first alignment pattern 26 and the teeth of each comb of the second alignment pattern 51 is used as a vernier to measure misalignment errors. For example, if in Figure 7 the central teeth 41, 66 were not aligned, but instead, the teeth 67c, 42c were aligned, the operator would know that the first alignment pattern 26 was misaligned 0.3 microns to the right. The operator would then attempt to make the proper adjustments (in a manner later described) to correct his misalignment. If the misalignment could not be corrected, the misalignment of the teeth of the comb would directly indicate the magnitude of any non-adjustable built-in error in the projection alignment apparatus. Note, that while in the present embodiment the teeth of the combs 30, 35, 40, 45 are spaced further apart than the teeth of the combs 55, 60, 65, 70 by 0.1 micron, the invention is not limited to such a spacing dimension and would cover any deliberate offset between the teeth to produce the vernier effect described above.

The first alignment patterns 26 are disposed in an array 76 on first target mask 25 as shown in Figure 2, and the second alignment patterns 51 are disposed in a corresponding array 81 as shown in Figure 3.

With reference to Figure 2, the array 76 has a centrally disposed first alignment pattern 26a located at the centre of the first target mask 25. A horizontal line of first alignment patterns 26b is located to the left of the centre first alignment pattern 26a, and a horizontal line of first alignment patterns 26c is located to the right of the centre first alignment pattern 26a. A vertical line of first alignment patterns 26d is disposed directly above the centre first alignment pattern 26a and a vertical line of first alignment patterns 26e is disposed directly below the centre first alignment pattern 26a. Forty-five degree offset diagonal lines of first alignment patterns 26f, 26g, 26h, 26i are also provided as shown. All the alignment patterns 26a-26i are identical to the first alignment pattern 26 shown in Figure 5. The alignment patterns 26a-26i are disposed on a checkerboard grid 75 of squares 77 in the array 76 shown in Figure 2.

With reference to Figure 3 it can be appreciated that each of the patterns 26a-26i has a corresponding second alignment pattern 51a-51i on the second target mask 50. Each of the second alignment patterns 51a-51i is identical to the second alignment pattern 51 shown in Figure 3. The alignment patterns 51a-51i are disposed upon a checkerboard grid 80 of squares 82 in the array 81 shown in Figure 3. When first target mask 25 is secured in the mask holder 12 and the second target mask 50 is properly secured in the wafer plane 22, the image of each of the first alignment patterns 26a-26i is superimposed upon a corresponding second alignment pattern 51a-51i on the second target mask 50.

The arrays 76, 81 generally, while not completely, cover the respective first target mask 25 and the second target mask 50. In order to completely cover the first target mask 25 and the second target mask 50, an alignment pattern 26, 51, would have to be placed in each square 77, 82, of the checkerboard grids 75, 80. Such arrays 76, 81 completely covering the first target masks 25, 50 would, however, be confusing to the operator. The present embodiment, therefore, includes the arrays 76, 81 illustrated to cover generally the first target mask 25 and second target mask 50 without undue confusion.

Having disclosed the basic structure of the target masks 25, 50, they are employed to align properly the mirrors 16 of the optical system 15 as follows:

As noted previously, the projection alignment apparatus includes means for producing adjustable relative movement between the mask 10 and the wafer 20 properly to position, the circuit pattern image from the mask 10 on the wafer 20. Means are also provided adjustably to position the mirrors 16 to vary the shape, size and orientation of the circuit pattern image projected on the wafer 20.

In one projection alignment apparatus presently utilised (the Perkin-Elmer MICRALIGN Model 120), the mask 10 or the wafer 20 are selectively adjustable. Here, of course, during the alignment procedure, the mask 10 has been replaced with the first target mask 25 and the wafer 20 has been replaced with the second target mask 50. Consequently, in the alignment procedure, the projection alignment apparatus 1 is selected adjustably to position the first target mask 25 or the second target mask 50.

With the operator looking through the viewer 17 and with the magnification set at low power, the second target mask 50 is placed in the wafer plane 22 and manually positioned to provide a rough alignment between the target masks 25, 50. The operator sees the images of the first alignment patterns 26 overlying the second target mask 50. Once the second target mask 50 has been manually positioned in the wafer plane to roughly align the images of the first alignment patterns 26 with the corresponding second alignment patterns 51 a vacuum is applied to the second target mask 50 to secure it in place. The operator then selects the two vertically spaced pairs of alignment patterns 26e, 51e and 26d, 51d for high power magnification and switches the projection alignment apparatus to high power magnification to view these two pattern pairs simultaneously in a split screen image. In this split screen image, one of the telescopes 18 or 19 is positioned over one of the pairs of alignment patterns 26e, 51e or 26d, 51d and the other scope is positioned over the other pair of alignment patterns. The operator activates a relative movement mechanism (not shown) to select the second target mask 50 for adjustable positioning. The relative movement mechanism is now operable to move the second target mask 50 in the X—Y plane and also to rotate it. The relative movement mechanism includes a joy stick for effecting movement in the X—Y plane and a theta control rotating knob (not shown) for producing rotational movement of the second target mask 50. Using the joy stick and a theta control (not shown) to move the second target mask 50, the operator aligns the four pairs of combs of each of the pairs of alignment patterns 26e, 51e and 26d, 51d.

Once these pairs of alignment patterns 26d, 51d and 26e, 51e are aligned as best as possible, the operator switches the projection alignment apparatus back to lower power magnification and moves one of the telescopes 18, 19 directly over the pair of centre alignment patterns 26a, 51a. A carriage movement switch (not shown) is then activated and both the first target mask 25 and the second target mask 50 are simultaneously moved to position, say, the telescope 18 over the farthest pair of alignment patterns 26b, 51b. The projection alignment apparatus is then selected into high power magnification and the operator studies the pair of alignment patterns 26b, 51b for misalignment errors. The operator notes the misalignment errors (if any), switches the magnification back to low power, and moves the target masks 25, 50 simultaneously until the telescope 18 is positioned directly over the farthest pair of alignment patterns 26c, 51c. The projection alignment apparatus is again switched to high power and the operator studies the pair of alignment patterns 26c, 51c for misalignment errors. The misalignment errors of this pair of alignment patterns 26c, 51c (if any) are compared with any misalignment errors noted as to the pair of alignment patterns 26b, 51b. Various errors can be determined from this comparison. For example, if the combs of the alignment pattern 26c are offset in one direction and the combs of the alignment pattern 26b are offset in the opposite direction, then a rotation error is present. Alternatively, if both the combs of the alignment patterns 26c, 26b are displaced to the outside of the corresponding combs of the alignment patterns 51c, 51b, then a magnification error is present (i.e. the array 76 is larger than the array 81). Conversely, if the combs of the alignment patterns 26b, 26c are displaced towards the inside from the combs of the alignment patterns 51b, 51c, then a reduction error is present in the image (i.e. the array 76 is smaller than the array 81). The vernier arrangement of the teeth of the combs is employed to measure directly the various misalignments and errors and make adjustments if possible. Rotational errors are first corrected by means of the theta control, if possible. If the rotational misalignment cannot be removed by the theta control, then a rotational error has been introduced by the mirrors 16 and the mirrors must be adjusted. A rotational adjustment knob (not shown) for the mirrors 16 is provided for this purpose. Magnification and reduction errors are corrected by means of a magnification adjustment knob (not shown) which adjusts the mirrors 16. The errors are corrected as best as possible using these controls. However, once the positions of the mirrors have been changed, it is necessary to go back to the beginning to realign the pairs of alignment patterns 26d, 51d and 26e, 51e (as previously described) in that adjustments of the mirrors 16 throws all previous alignments out of adjustment. This procedure is sequentially repeated until all of the alignment patterns 26a-26i, and 51a-51i are aligned as best as possible. Once this alignment is achieved the mirrors 16 of the optical system 15 have been aligned to the best extent possible and the projection alignment apparatus is ready for microminiature integrated circuit manufacture. The target masks 25, 50 are replaced with the circuit mask 10 and the wafer 20 and microminiature integrated circuit fabrication is begun. Certain errors will be created by the temperature of the mirrors or by small manufacturing defects. These errors cannot be removed but they can be measured directly from the vernier arrangement of the combs so that the operator is cognizant of any non-adjustable built-in error and can give them consideration as appropriate.

The arrays 76, 81 of the alignment patterns 26a-25i, 51a-51i provide enough space between pairs of alignment patterns to permit the operator to focus on a selected pair of alignment patterns without undue confusion. The arrays 76, 81 also generally cover the wafer surface so that any irregularities in the projected image of the first alignment patterns can be determined. For example, it is possible that all of the pairs of alignment patterns would be aligned except for the outermost pair of alignment patterns 26f, 51f (to choose a pair at random). The singular misalignment of this pair of alignment patterns 26f, 51f would indicate a defect in the mirrors 16 causing a localised irregular spot in the image of the first alignment patterns. The vernier arrangement of the combs would be used to determine the magnitude of this irregularity and the operator would be cognisant of the irregularity and give it due consideration in scheduling production runs of microminiature integrated circuits amongst various projection alignment apparatus as appropriate.

In view of the foregoing, it should be appreciated that the projection alignment apparatus according to the present invention and described above provides relatively simply and efficiently aligning the mirrors of the projection alignment apparatus to produce high quality, accurate microminiature integrated circuits in silicon wafer fabrication.

## Claims

1. A projection alignment apparatus comprising a circuit mask holder (12) suitable for securing a circuit mask (10), said circuit mask having a circuit pattern thereon; means for securing a wafer (20) in a wafer plane (22); an optical system (15); and a light source (5) for projecting light through said circuit mask to produce an image of said circuit pattern through said optical system on said wafer; characterised by comprising: a first target mask (25) having at least two lines of first alignment patterns (26a-26i) thereon, at least one (26d, 26e) of said first lines extending vertically through the centre of the first target mask, at least one (26b, 26c) of said first lines extending horizontally through said centre, a horizontally disposed pattern (35, 45) on each of said first alignment patterns comprising a comb pattern having a plurality of teeth arranged in a vertically exending row including a central tooth, the teeth being evenly spaced a first predetermined distance apart and a vertically disposed pattern (30, 40) on each of said first alignment patterns comprising a comb pattern having a plurality of teeth arranged in a horizontally extending row including a central tooth, the teeth being evenly spaced the first predetermined distance apart, said first target mask being secured in said mask holder; a second target mask (50) having at least two lines of second alignment patterns (51a-51i) thereon, at least one (51d, 51e) of said second lines extending vertically through the centre of the second target mask, at least one (51b, 51c) of said second lines extending horizontally through said centre, a horizontally disposed pattern (60, 70) on each of said second alignment patterns comprising a comb pattern having a plurality of teeth arranged in a vertically extending row including a central tooth, the teeth being evenly spaced a second predetermined distance apart and a vertically disposed pattern (55, 65) on each of said second alignment patterns comprising a comb pattern having a plurality of teeth arranged in a horizontally extending row including a central tooth, the teeth being evenly spaced the second predetermined distance apart; said second target mask being secured in said wafer plane, said light source being arranged to project light through said first target mask to carry the image of said first alignment patterns through said optical system and be superimposed upon said second target mask, means for arranging said horizontally and vertically disposed patterns of the first target mask so that their images abut the corresponding horizontally and vertically disposed patterns of the second target mask in an aligned position where the central teeth of the respective patterns are aligned, the first and second predetermined distances being such that the alignment of teeth other than the central teeth provides a direct measurement of the degree and direction of misalignment.

2. Apparatus as claimed in claim 1 characterised by including means for producing relative movement between said first target mask and said second target mask to attempt to put said first alignment patterns and said second alignment patterns in said aligned position.

3. An apparatus as claimed in claim 1 or 2 characterised in that said first target mask has at least four lines of first alignment patterns thereon, at least two of which are vertically extending on opposite sides of the centre of the first target mask, and at least two of said lines being horizontally extending on opposite sides of the centre of the first target mask, said second target mask having at least four lines of second alignment patterns thereon, at least two of which are vertically extending on opposite sides of the centre of the second target mask, and at least two of said lines being horizontally extending on opposite sides of, the centre of the second target mask.

4. An apparatus as claimed in claim 3 characterised in that said at least four lines of first alignment patterns of said first target mask are superimposed upon and aligned with said at least four lines of second alignment patterns of said second target mask in said aligned position.

5. An apparatus as claimed in claim 4 characterised in that said first target mask includes at least first alignment patterns disposed on each side of said centre of the first target mask along diagonal lines running through said centre of the first target mask from an upper left hand corner to a lower right hand corner and from a lower left hand corner of said mask to an upper right hand corner, and that said second target mask includes second alignment patterns disposed on each side of said centre of the second target mask along diagonal lines running through said centre of the second target mask from an upper left hand corner to a lower right hand corner and from a lower left hand corner to an upper right corner of said mask; the arrangement being such that in said aligned position, each of said first alignment patterns is superimposed upon and aligned with a corresponding second alignment pattern.

6. An apparatus as claimed in claim 1 or 2 characterised in that each of said first alignment patterns has a pattern centre and one of said horizontally disposed patterns is disposed to the left of said pattern centre and one of said horizontally disposed patterns is disposed to the left of said pattern centre, and one of said vertically disposed patterns is disposed above said pattern centre and one of said vertically disposed patterns is disposed below said pattern centre.

7. Apparatus as claimed in claim 6 characterised in that each of said second alignment patterns has a pattern centre and one of said horizontally disposed patterns is disposed to the left of said pattern centre and one of said horizontally disposed patterns is disposed to the right of said pattern centre, and one of said vertically disposed patterns is disposed above said pattern

13     **0 091 199**     14

centre, and one of said vertically disposed patterns is disposed below said pattern centre.

8. Apparatus as claimed in claim 7 characterised in that said horizontally and vertically disposed patterns of each of said first alignment patterns are arranged in a first box type configuration, and said horizontally and vertically disposed patterns of each of said second alignment pattern are disposed in a second box type configuration, the arrangement being such that in said aligned position said horizontally and vertically disposed patterns of each of said second alignment patterns fit within the first box type configuration and abut said horizontal and vertical patterns of the corresponding second alignment pattern.

9. An apparatus as claimed in any preceding claim characterised in that each of said second alignment patterns has a cross hair disposed at its centre and each of said first alignment pattern has a cross hair bracket disposed at its centre, said cross hair being centred in said cross hair bracket in said aligned position.

**Patentansprüche**

1. Projectionsausrichtvorrichtung mit einem Schaltungsmaskenhalter (12) zur Befestigung einer Schaltungsmaske (10), die ein darauf ausgebildetes Schaltungsmuster trägt, mit Einrichtungen zur Befestigung einer Halbleiterscheibe (20) in einer Halbleiterebene (22), mit einem optischen System (15) und mit einer Lichtquelle (5) zur Projektion von Licht durch die Schaltungsmaske hindurch zur Erzeugung eines Bildes des Schaltungsmusters durch das optische System hindurch auf die Halbleiterscheibe, dadurch gekennzeichnet, daß eine erste Zielmaske (25) vorgesehen ist, die zumindestens zwei Linien von ersten Ausrichtmustern (26a bis 26i) trägt, daß zumindestens eine (26d, 26e) der ersten Linien sich in Vertikalrichtung durch den Mittelpunkt der ersten Zielmaske erstreckt, während sich zumindestens eine (26b, 26c) der ersten Linien in Horizontalrichtung durch diesen Mittelpunkt erstreckt, daß ein horizontal angeordnetes Muster (35, 45) auf jedem der ersten Ausrichtmuster ein Kamm-Muster umfaßt, das eine Vielzahl von Zähnen aufweist, die in einer sich in Vertikalrichtung erstreckenden Reihe angeordnet sind, die einen in der Mitte liegenden Zahn einschließt, wobei die Zähne gleichmäßig mit einem ersten vorgegebenen Abstand voneinander angeordnet sind, daß ein vertikal angeordnetes Muster (30, 40) auf jedem der ersten Ausrichtmuster ein Kamm-Muster umfaßt, das eine Vielzahl von Zähnen aufweist, die in einer sich in Horizontalrichtung erstreckenden Reihe angeordnet sind und einen in der Mitte liegenden Zahn einschließen, wobei die Zähne gleichmäßig mit einem ersten vorgegebenen Abstand voneinander angeordnet sind, daß die erste Zielmaske in dem Maskenhalter befestigt ist, daß eine zweite Zielmaske (50) vorgesehen ist, die zumindestens zwei Linien von zweiten Ausrichtmustern (51a bis 51i) trägt, daß sich zumindestens eine (51d, 51e) der zweiten Linien in Vertikalrichtung durch den Mittelpunkt der zweiten Zielmaske erstreckt, während sich zumindestens eine (51b, 51c) der zweiten Linien in Horizontalrichtung durch diesen Mittelpunkt erstreckt, daß ein horizontal angeordnetes Muster (60, 70) auf jedem der zweiten Ausrichtmuster ein Kamm-Muster mit einer Vielzahl von Zähnen umfaßt, die in einer sich in Vertikalrichtung erstreckenden Reihe angeordnet sind, die einen in der Mitte angeordneten Zahn einschließt, daß die Zähne gleichförmig mit einem zweiten vorgegebenen Abstand voneinander angeordnet sind, daß ein vertikal angeordnetes Muster (55, 65) auf jedem der zweiten Ausrichtmuster ein Kamm-Muster mit einer Vielzahl von Zähnen umfaßt, die in einer sich in Horizontalrichtung erstreckenden Reihe angeordnet sind, die einen mittleren Zahn einschließt, daß die Zähne gleichförmig mit dem zweiten vorgegebenen Abstand voneinander angeordnet sind, daß die zweite Zielmaske in der Halbleiterscheibenebene befestigt ist, daß die Lichtquelle so angeordnet ist, daß sie Licht durch die erste Zielmaske hindurch projiziert, um das Bild der ersten Ausricht muster durch das optische System weiterzuleiten, so daß es auf der zweiten Zielmaske überlagert wird, daß Einrichtungen zur Anordnung der in Horizontalrichtung und in Vertikalrichtung angeordneten Muster der ersten Zielmaske derart vorgesehen sind, daß ihre Bilder auf die entsprechenden in Horizontalrichtung und in Vertikalrichtung angeordneten Muster der zweiten Zielmaske in einer ausgerichteten Position auftreffen, in der die mittleren Zähne der jeweiligen Muster miteinander ausgerichtet sind, und daß die ersten und zweiten vorgegebenen Abstände derart sind, daß die Ausrichtung der anderen als der in der Mitte liegenden Zähne ein direktes Maß des Ausmaßes und der Richtung der Fehlausrichtung ergibt.

2. Vorrichtung nach Anspruch 1, dadurch gekennzeichnet, daß sie Einrichtungen zur Erzeugung einer Relativbewegung zwischen der ersten Zielmaske und der zweiten Zielmaske aufweist, die es ermöglichen, die ersten Ausrichtmuster und die zweiten Ausrichtmuster in die ausgerichtete Position zu bringen.

3. Vorrichtung nach Anspruch 1 oder 2, dadurch gekennzeichnet, daß die erste Zielmaske zumindestens vier Linien von ersten Ausrichtmustern trägt, von denen zumindestens zwei sich in Vertikalrichtung auf gegenüberliegenden Seiten des Mittelpunktes der ersten Zielmaske erstrecken, während sich zumindestens zwei der Linien in Horizontalrichtung auf gegenüberliegenden Seiten des Mittelpunktes der ersten Zielmaske erstrecken, daß die zweite Zielmaske zumindestens vier Linien von zweiten Ausrichtmustern trägt, von denen sich zumindestens zwei in Vertikalrichtung auf gegenüberliegenden Seiten des Mittelpunktes der zweiten Zielmaske erstrecken, während sich zumindestens zwei der Linien in Horizontalrichtung auf gegenüberliegenden Seiten des Mittelpunktes der zweiten Zielmaske erstrecken.

8

4. Vorrichtung nach Anspruch 3, dadurch gekennzeichnet, daß die zumindestens vier Linien der ersten Ausrichtmister der ersten Zielmaske in der ausgerichteten Position mit den zumindestens vier Linien der zweiten Ausrichtmuster auf der zweiten Zielmaske überlagert und mit diesen ausgerichtet sind.

5. Vorrichtung nach Anspruch 4, dadurch gekennzeichnet, daß die erste Zielmaske zumindestens erste Ausrichtmuster einschließt, die auf jeder Seite des Mittelpunktes der ersten Zielmaske entlang diagonaler Linien angeordnet sind, die durch den Mittelpunkt der ersten Zielmaske von einer oberen linken Ecke zu einer unteren rechten Ecke und von einer unteren linken Ecke der Maske zu einer oberen rechten Ecke verlaufen, und daß die zweite Zielmaske zweite Ausrichtmuster einschließt, die auf jeder Seite des Mittelpunktes der zweiten Zielmaske entlang diagonaler Linien angeordnet sind, die durch den Mittelpunkt der zweiten Zielmaske von einer oberen linken Ecke zu einer unteren rechten Ecke und von einer unteren linken Ecke zu einer oberen rechten Ecke der Maske verlaufen, wobei die Anordnung derart ist, daß in der ausgerichteten Position jedes der ersten Ausrichtmuster mit einem entsprechenden zweiten Ausrichtmuster überlagert und ausgerichtet ist.

6. Vorrichtung nach Anspruch 1 oder 2, dadurch gekennzeichnet, daß jedes der ersten Ausrichtmuster einen Mustermittelpunkt aufweist, daß eines der horizontal angeordneten Muster auf der linken Seite des Mustermittelpunktes angeordnet ist, daß eines der horizontal angeordneten Muster auf der linken Seite des Mustermittelpunktes angeordnet ist, und daß eines der vertikal angeordneten Muster oberhalb des Mustermittel punktes angeordnet ist und daß eines der vertikal angeordneten Muster unterhalb des Mustermittelpunktes angeordnet ist.

7. Vorrichtung nach Anspruch 6, dadurch gekennzeichnet, daß jedes der zweiten Ausrichtmuster einen Mustermittelpunkt aufweist, daß eines der horizontal angeordneten Muster links von diesem Mustermittelpunkt angeordnet ist und eines der horizontal angeordneten Muster rechts von dem Mustermittelpunkt angeordnet ist, und daß eines der vertikal angeordneten Muster oberhalb des Mustermittelpunktes angeordnet ist und eines der vertikal angeordneten Muster unterhalb des Mustermittelpunktes angeordnet ist.

8. Vorrichtung nach Anspruch 7, dadurch gekennzeichnet, daß die horizontal und vertikal angeordneten Muster jedes der ersten Ausrichtmuster in einer ersten kastenförmigen Form angeordnet sind, daß die horizontal und vertikal angeordneten Muster jedes der zweiten Ausrichtmuster in einer zweiten kastenförmigen Form angeordnet sind und daß die Anordnung derart ist, daß in der ausgerichteten Position die horizontal und vertikal angeordneten Muster jedes der zweiten Ausrichtmuster in die erste kastenförmige Form passen und auf die horizontalen und vertikalen Muster des entsprechenden zweiten Ausrichtmusters auftreffen.

9. Vorrichtung nach einem der vorhergehenden Ansprüche, dadurch gekennzeichnet, daß jedes der zweiten Ausrichtmuster ein an seinem Mittelpunkt angeordnetes Fadenkreuz aufweist, daß jedes der ersten Ausrichtmuster an seinem Mittelpunkt eine Fadenkreuzumrandung aufweist und daß das Fadenkreuz in der ausgerichteten Position in der Fadenkreuzumrandung zentriert ist.

**Revendications**

1. Appareil d'alignement par projection comprenant un support de masque de circuit (12) permettant de fixer un masque de circuit (10), ce masque de circuit portant un motif de circuit; des moyens pour fixer une tranche (20) dans un plan de tranche (22); un système optique (15); et une source lumineuse (5) pour projeter de la lumière à travers le masque de circuit pour produire une image du motif du circuit par le système optique sur la tranche; caractérisé en ce qu'il comprend: un premier masque cible (25) comportant au moins deux lignes de premiers motifs d'alignement (26a-26i), au moins une (26d, 26e) des premieres lignes s'étendant verticalement en passant par le centre du premier masque cible, au moins une (26b, 26c) des premières lignes s'étendant horizontalement en passant par ce centre, un motif disposé horizontalement (35, 45) sur chacun des premiers motifs d'alignement comprenant un motif en peigne muni d'une pluralité de dents disposées en une rangée s'étendant verticalement comprenant une dent centrale, les dents étant régulièrement espacées d'une première distance prédéterminée, et un motif disposé verticalement (30, 40) sur chacun des premiers motifs d'alignement comprenant un motif en peigne muni d'une pluralité de dents disposées selon une rangée s'étendant horizontalement comprenant une dent centrale, les dents étant régulièrement espacées de la première distance prédéterminée, le premier masque cible étant fixé au support de masque; un second masque cible (50) comprenant au moins deux lignes de seconds motifs d'alignement (51a-51i), au moins une (51d, 51e) des secondes lignes s'étendant verticalement en passant par le centre du second masque cible, au moins une (51b, 51c) des secondes lignes s'étendant horizontalement en passant par ce centre, un motif disposé horizontalement (60, 70) sur chacun des seconds motifs d'alignement comprenant un motif en peigne comportant une pluralité de dents disposées en une rangée s'étendant verticalement et comprenant une dent centrale, les dents étant régulièrement espacées d'une seconde distance prédéterminée et un moif disposé verticalement (55, 65) sur chacun des seconds motifs d'alignement comprenant un motif en peigne muni d'une pluralité de dents disposées en une rangée s'étendant horizontalement comprenant une dent centrale, les dents étant régulièrement espacées de la seconde distance prédéterminée; le second masque cible étant fixé dans le plan de la tranche, la source lumineuse étant disposée pour projeter de la lumière à travers le premier masque cible pour transmettre l'image des premiers motifs d'alignement à travers le système optique et la superposer au second masque cible, des moyens pour agencer les motifs disposés horizontalement et verticalement du premier masque cible de sorte que leurs images rencontrent les motifs disposés horizontalement et verticalement de façon correspondante du second masque cible selon une position alignée où les dents centrales des motifs respectifs sont alignées, les première et seconde distances prédéterminées étant telles que l'alignement des dents autres que les dents centrales fournit une mesure directe du degré et de la direction du défaut d'alignement.

2. Appareil selon la revendication 1, caractérisé en ce qu'il comprend des moyens pour produire un mouvement relatif entre le premier masque cible et le second masque cible pour essayer de placer les premiers motifs d'alignement et les seconds motifs d'alignement dans ladite position alignée.

3. Appareil selon l'une des revendications 1 ou 2, caractérisé en ce que le premier masque cible comprend au moins quatre lignes de premiers motifs d'alignement dont au moins deux s'étendent verticalement sur les côtés opposés du centre du premier masque cible et au moins deux s'étendent horizontalement sur les côtés opposés du centre du premier masque cible, le second masque cible comprenant au moins quatre lignes de seconds motifs d'alignement dont au moins deux s'étendent verticalement sur les côtés opposés du centre du second masque cible, et au moins deux s'êtendent horizontalement sur les côtés opposés du centre du second masque cible.

4. Appareil selon la revendication 3, caractérisé en ce que lesdits au moins quatre lignes de premiers motifs d'alignement du premier masque cible sont superposées et alignées avec lesdites au moins quatre lignes de seconds motifs d'alignement du second masque cible dans ladite position alignée.

5. Appareil selon la revendication 4, caractérisé en ce que le premier masque cible comprend au moins des premiers motifs d'alignement disposés de chaque côté du centre du premier masque cible selon des lignes diagonales passant par le centre du premier masque à partir d'un coin gauche supérieur vers un coin droit inférieur et à partir d'un coin gauche inférieur du masque vers un coin droit supérieur, et en ce que le second masque cible comprend des seconds motifs d'alignement disposés de chaque côté du centre du second masque cible selon des lignes diagonales passant par le centre du second masque cible à partir d'un coin supérieur gauche vers un coin inférieur droit et à partir d'un coin inférieur gauche vers un coin supérieur droit de ce masque; l'agencement étant tel que, dans ladite position alignée, chacun des premiers motifs d'alignement est superposé et aligné avec un seconds motif d'alignement correspondant.

6. Appareil selon l'une des revendications 1 ou 2, caractérisé en ce que chacun des premiers motifs d'alignement comprend un centre de motif et en ce que l'un des motifs disposés horizontalement est disposé à la gauche du centre de motif et l'un des motifs disposés horizontalement est disposé à la droite du centre de motif, et l'un des motifs disposés verticalement est disposé au dessus du centre de motif et l'un des motifs disposés verticalement est disposé en dessous du centre de motif.

7. Appareil selon la revendication 6, caractérisé en ce que chacun des seconds motifs d'alignement comprend un centre de motif et l'un des motifs disposés horizontalement est disposé à la gauche de ce centre de motif et l'un des motifs disposés horizontalement est disposé à la droite de ce centre de motif, et l'un des motifs disposés verticalement est disposé au dessus de ce centre de motif, et l'un des motifs disposés verticalement est disposé en dessous de ce centre de motif.

8. Appareil selon la revendication 7, caractérisé en ce que les motifs disposés horizontalement et verticalement de chacun des premiers motifs d'alignement sont disposés selon une première configuration du type boîte, et les motifs disposés horizontalement et verticalement de chacun des seconds motifs d'alignement sont disposés selon une seconde configuration du type boîte, l'agencement étant tel que, dans la position alignée, les motifs disposés horizontalement et verticalement de chacun des seconds motifs d'alignement s'adaptent à la première configuration du type boîte et se conforment aux motifs horizontaux et verticaux du second motif d'alignement correspondant.

9. Appareil selon l'une quelconque des revendications précédentes, caractérisé en ce que chacun des seconds motifs d'alignement comprend en son centre une croisée et en ce que chacun des premiers motifs d'alignement comprend une croisée double disposée en son centre, ladite croisée étant centrée dans la croisée double pour la position alignée.

0 091 199

Fig.1

Fig.2

Fig.3

1

Fig.4

Fig.5

Fig.6

Fig.7